# FASCICULE DE BREVET EUROPEEN

(11) **EP 0 846 304 B1**
(45) Date de publication et mention de la délivrance du brevet: **26.06.2002**
(21) Numéro de dépôt: 97923269.1
(22) Date de dépôt: 07.04.1997
(51) Int. Cl.: G06K 7/06

(54) **BOITIER DE RACCORDEMENT ELECTRONIQUE, A UN ORDINATEUR INDIVIDUEL, EQUIPE D'UN CONNECTEUR POUR UNE CARTE A PUCE**
ELEKTRONISCHES VERBINDUNGSGEHÄUSE FÜR PERSONALCOMPUTER MIT CHIPKARTENVERBINDER
ELECTRONIC CONNECTION BOX FOR A PERSONAL COMPUTER WITH A SMART CARD CONNECTOR

(30) Priorité: 18.04.1996 FR 9604842
(43) Date de publication de la demande: 10.06.1998
(60) Demande divisionnaire: 98201406.0
(73) Titulaire: ITT MANUFACTURING ENTERPRISES, INC., Wilmington, Delaware 19801 (US)
(72) Inventeur: BRICAUD, Hervé, F-39100 Dole (FR); BIERMANN, Werner, D-73650 Winterbach (DE)
(74) Mandataire: Kohn, Philippe
(86) Numéro de dépôt international: IB9700595
(87) Numéro de publication internationale: WO9739418

(56) Documents cités:
- EP-A- 0 274 288
- EP-A- 0 480 334
- EP-A- 0 595 025
- DE-A- 4 138 342
- DE-U- 29 505 678

## Description

La présente invention concerne un boîtier de raccordement électronique, notamment pour un ordinateur individuel.

L'invention concerne plus particulièrement un boîtier de raccordement en forme générale de carte qui peut être introduit dans une fente de forme complémentaire de l'ordinateur en vue d'établir un ou plusieurs raccordements entre par exemple l'ordinateur et des unités périphériques.

Dans le cas de son application aux ordinateurs personnels, un tel boîtier de raccordement électronique, aussi appelé "carte PC" répond désormais à une standardisation correspondant à la norme PCMCIA ("Personal Computer Memory Card International Association") qui concerne notamment les dimensions extérieures du boîtier de raccordement afin de permettre son insertion dans n'importe quel ordinateur personnel comportant une fente d'introduction dont les dimensions sont complémentaires et correspondent à la norme PCMCIA.

Ainsi, le boîtier de raccordement électronique en forme générale de carte est du type comportant une coquille métallique, qui peut notamment être réalisée en deux parties, à parois principales planes parallèles et opposées, supérieure et inférieure, qui délimitent entre elles une cavité, ouverte à ses deux extrémités longitudinales opposées et délimitée transversalement par deux parois latérales opposées conformées en forme de rails de guidage du boîtier, à l'intérieur de laquelle est agencée une plaque intermédiaire, notamment une plaque à circuit imprimé, qui s'étend sensiblement à mi-hauteur entre les faces internes en vis-à-vis des parois principales et parallèlement à ces dernières.

La plaque intermédiaire à circuit imprimé peut porter différents composants électroniques et, à ses extrémités longitudinales opposées, des connecteurs de raccordement qui débouchent de part et d'autre dans les extrémités longitudinales ouvertes du boîtier de manière à assurer le raccordement de ce dernier avec l'ordinateur en ce qui concerne le connecteur agencé à l'extrémité interne du boîtier qui est introduite dans l'ordinateur et, le cas échéant, à un autre appareil ou une ligne de communication en ce qui concerne l'autre connecteur agencé à l'extrémité longitudinale externe du boîtier qui peut, par exemple, recevoir une prise de raccordement à une ligne téléphonique.

Pour certaines applications, et par exemple pour autoriser un utilisateur d'un ordinateur personnel à accéder à un réseau de télécommunications, il est apparu nécessaire de pouvoir associer le boîtier de raccordement électronique à une carte à circuit(s) intégré(s) à contact, aussi appelée communément carte à puce, cette dernière comportant des informations en mémoire qui sont exploitées par le boîtier de raccordement et l'ordinateur associé lors de la connexion de l'ordinateur avec un réseau de télécommunications.

Ce principe d'autorisation d'accès d'un utilisateur titulaire d'une carte à puce est couramment appliqué dans le domaine de la radiotéléphonie, la carte à puce correspondant à l'une ou l'autre des deux normes dimensionnelles, et le plus souvent à la carte miniature, aussi appelée carte "MICRO SIM", dont l'encombrement est particulièrement réduit.

La connexion d'une telle carte à puce avec un quelconque dispositif électronique d'exploitation de données qu'elle contient est couramment assurée par l'intermédiaire d'un connecteur de conception générale connue qui comporte un support en matériau isolant comportant un logement ouvert dans sa face supérieure qui reçoit la carte à puce comportant sur sa face principale des plages conductrices qui coopèrent avec les extrémités de contact d'éléments de contact électrique agencées dans le fond du logement du support isolant du connecteur.

Il a déjà été proposé d'associer un tel connecteur à un boîtier de raccordement PCMCIA mais les conceptions connues à ce jour ont pour principal inconvénient d'affecter de manière importante la structure du boîtier en en réduisant ainsi de manière inacceptable la rigidité et les caractéristiques de blindage électronique que la coquille métallique doit impérativement assurer pour protéger les composants internes au boîtier de raccordement électronique.

On connaît du document DE-U-29.505.678 un boîtier de raccordement électronique au format carte "PCMCIA" pour connecter une carte à circuits intégrés, ou carte à puce, à contact à un appareil électronique comportant une fente complémentaire au format "PCMCIA". Ce boitier divulgue les caractéristiques du préambule de la revendication 1.

On connaît par ailleurs du document DE-A-4.138.432 un connecteur électrique pour une carte à puce pouvant par exemple être intégré dans un boîtier électronique du type mentionné ci-dessus.

L'invention a pour but de proposer une nouvelle conception d'un boîtier de raccordement électronique de type mentionné précédemment qui permette de lui associer une carte à puce sans modifier les caractéristiques dimensionnelles et structurelles du boîtier normalisé, tout en permettant une extraction aisée de la carte hors du connecteur et du boîtier.

Dans ce but, l'invention propose un boîtier de raccordement électronique tel que défini à la revendication 1.

Selon d'autres caractéristiques préférentielles de l'invention :
- le chariot d'extraction est rappelé élastiquement vers la position d'extraction de la carte et il est retenu dans la position introduite de la carte par des moyens de verrouillage automatique
- les moyens de verrouillage automatique du chariot comportent un doigt escamotable de verrouillage porté par le chariot et qui, en position introduite de la carte, est reçu dans un trou en vis à vis de la paroi principale supérieure du boîtier vers lequel il est rappelé élastiquement ;
- les moyens de verrouillage automatique du chariot comportent une barre de verrouillage escamotable portée par le support du connecteur et qui s'étend normalement dans une position de verrouillage de la carte en position introduite vers laquelle elle est rappelée élastiquement et dans laquelle la barre s'étend en regard du bord transversal de la carte ;
- la barre de verrouillage s'étend normalement en regard de la fente d'introduction de la carte dans le boîtier, et la barre de verrouillage comporte un profil de came avec lequel coopère le bord transversal arrière de la carte lors de son introduction pour provoquer l'escamotage de la barre de verrouillage selon une direction sensiblement verticale ;
- le support du connecteur comporte des moyens pour son positionnement qui coopèrent avec des moyens complémentaires de la plaque intermédiaire
- les moyens de positionnement du connecteur sont des moyens par coopération de formes complémentaires ;
- le support du connecteur comporte au moins une partie formant entretoise qui s'étend à travers la plaque intermédiaire et dont la face inférieure d'extrémité libre est adjacente à la face interne en vis à vis de la paroi principale inférieure ;
- la partie formant entretoise s'étend à travers une ouverture de forme complémentaire de la plaque intermédiaire ;
- il est prévu des moyens d'obturation au moins partielle de la fente d'introduction de la carte dans le boîtier ;
- les moyens d'obturation sont des moyens déformables élastiquement qui, au repos, s'étendent en regard de la fente d'introduction et qui sont susceptibles de s'effacer automatiquement lors de l'introduction de la carte ;
- les moyens d'obturation sont portés par le support du connecteur ;
- les moyens d'obturation comportent une lèvre d'obturation qui est montée mobile verticalement par rapport au support du connecteur et qui comporte un profil de came avec lequel coopère le bord transversal arrière de la carte lors de son introduction pour provoquer l'escamotage de la lèvre selon une direction sensiblement verticale ;
- la lèvre est une lame profilée portée par le support du connecteur par l'intermédiaire de deux bras déformables élastiquement qui s'étendent longitudinalement le long de bords du support parallèles à la direction d'insertion de la carte;
- la lèvre d'obturation appartient à un joint d'obturation monté dans un évidement formé dans la face supérieure du support du connecteur ;
- la paroi principale supérieure comporte, sur sa face interne, un bossage qui, lorsque la carte est en position introduite, s'étend en regard d'une portion du bord transversal avant de la carte pour éviter tout échappement accidentel de cette dernière hors du boîtier ;
- le support comporte un logement ouvert dans sa face supérieure, et le fond du logement de la carte comporte une rampe qui, provoque un soulèvement du bord transversal avant de la carte lors de son mouvement d'extraction hors du boîtier.

D'autres caractéristiques et avantages de l'invention apparaîtront à la lecture de la description détaillée qui suit pour la compréhension de laquelle on se reportera aux dessins annexés dans lesquels :
- la figure 1 est une vue en perspective éclatée des principaux composants d'un boîtier de raccordement réalisé conformément aux enseignements de l'invention ;
- la figure 2 est une vue de détail en perspective du boîtier illustré à la figure 1 qui illustre à plus grande échelle l'agencement de la fente d'introduction de la carte dans le boîtier
- la figure 3 est une vue de dessus d'un premier mode de réalisation d'un connecteur pour carte à puce destiné à être intégré dans un boîtier de raccordement ;
- la figure 4 est une vue latérale selon la flèche F4 de la figure 3 ;
- la figure 5 est une vue latérale selon la flèche F5 de la figure 3 ;
- la figure 6 est une vue de dessus, avec arrachements partiels, du boîtier de raccordement et qui illustre l'implantation du connecteur sur la plaque à circuit imprimé et à proximité de la fente d'introduction de la carte ;
- la figure 7 est une vue en section partielle selon la ligne 7-7 de la figure 6 ;
- la figure 8 est une vue similaire à celle de la figure 3 qui illustre un deuxième mode de réalisation du connecteur qui est ici équipé d'une première variante de réalisation du chariot d'extraction de la carte et sur laquelle le chariot et la carte sont représentés en position introduite de la carte et sont aussi représentés en silhouette en position partiellement extraite de la carte ;
- les figures 9 et 10 sont des vues similaires à celles des figures 4 et 5 selon les flèches F9 et F10 de la figure 8 ;
- la figure 11 est une vue similaire à celle de la figure 8 qui illustre un troisième mode de réalisation du connecteur qui est ici équipé d'une deuxième variante de réalisation du chariot d'extraction de la carte et sur laquelle le chariot et la carte sont représentés en position introduite de la carte et sont aussi représentés en silhouette en position partiellement extraite de la carte ;
- la figure 11A est une vue en perspective selon la flèche F11A de la figure 11 qui illustre à plus grande échelle la conception du chariot d'extraction ;
- la figure 12 est une vue en perspective d'un quatrième mode de réalisation du support en matériau isolant du connecteur destiné à être équipé des moyens d'obturation de la fente illustrés à la figure 13 ;
- la figure 13 est une vue en perspective du dispositif d'obturation destiné à équiper le connecteur dont l'isolant est représenté à la figure 12 ;
- la figure 14 est une vue similaire à celle de la figure 6 qui illustre le connecteur et le dispositif d'obturation représentés aux figures 12 et 13 avec la carte en position introduite ;
- la figure 15 est une vue similaire à celle de la figure 7, en section partielle selon la ligne 15-15 de la figure 14 ;
- la figure 16 est une vue similaire à celle de la figure 15 sans la carte ;
- les figures 17 et 18 sont des vues similaires à celles des figures 15 et 16 qui illustrent une variante de réalisation du dispositif d'obturation qui fait aussi fonction de dispositif de verrouillage de la carte en position introduite dans le boîtier ;
- la figure 19 est une vue similaire à celle de la figure 18 qui illustre une variante de réalisation du dispositif de verrouillage et d'obturation illustré à la figure 18 en association avec une variante de réalisation du chariot d'extraction automatique illustré à la figure 11 ;
- la figure 20 est une vue similaire à celle de la figure 18 qui illustre une variante de réalisation des moyens de verrouillage de la carte et du chariot en position carte introduite ;
- la figure 21 est une vue selon la ligne 21-21 de la figure 20;
- la figure 22 est une vue similaire à celle de la figure 15 qui illustre une autre variante de réalisation des moyens d'obturation de la fente sous la forme d'un joint souple d'obturation ;
- la figure 23 est une vue similaire à celle de la figure 22 qui illustre le joint d'obturation lorsqu'elle la carte est en position introduite dans le boîtier de raccordement ;
- la figure 24 est une vue de dessus du connecteur illustré aux figures 22 et 23 qui illustre l'agencement du joint d'obturation dans la partie avant du connecteur.

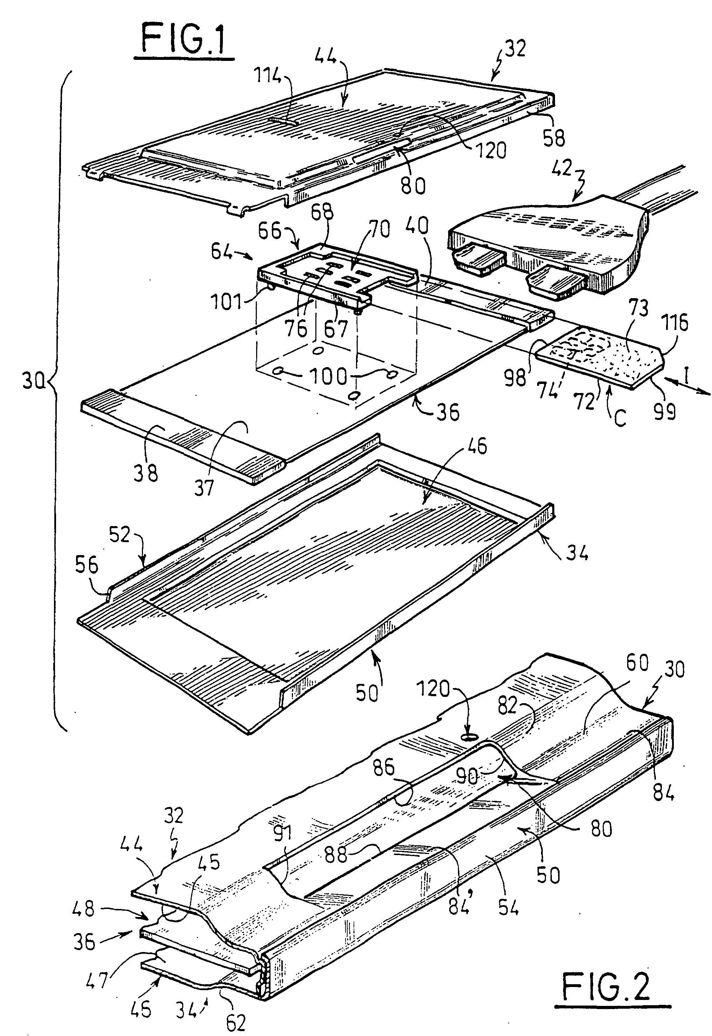

On a représenté à la figure 1 un boîtier de raccordement 30, de conception générale connue, qui est essentiellement constitué par une coquille métallique comportant une demi-coquille supérieure 32 et une demi-coquille inférieure 34 dont chacune est une pièce en tôle découpée, emboutie et pliée.

Les formes et les dimensions de la coquille en deux parties 32, 34 sont conformes à la norme PCMCIA qui, outre ses dimensions, détermine aussi les détails de conformation de la coquille de manière à permettre son introduction dans une fente normalisée (non représentée) de forme complémentaire appartenant par exemple à un ordinateur personnel.

A l'intérieur du boîtier 30, entre les demi-coquilles 32 et 34, est agencé une plaque à circuit imprimé 36 qui s'étend parallèlement au plan général du boîtier et qui porte, à chacune de ses extrémités longitudinales opposées, des connecteurs 38, 40, illustrés de manière schématique sur la figure 1, l'un ou l'autre des connecteurs pouvant, selon les applications, être remplacé par un élément de même dimension constituant un bouchon de fermeture du boîtier 30 à son extrémité longitudinale correspondante.

La plaque à circuit imprimé qui constitue la plaque intermédiaire du boîtier peut recevoir, sur ses deux faces, des composants électroniques (non représentés).

Comme on l'a représenté sur la figure 1, l'un des connecteurs 40 peut par exemple être conçu pour permettre le branchement d'une prise 42 qui assure le raccordement du boîtier 30 par exemple avec une ligne de télécommunication.

La demi-coquille supérieure 32 délimite une paroi principale supérieure plane 44 qui, en coopération avec la paroi principale inférieure plane 46 de la demi-coquille inférieure 34, délimite une cavité interne 48 (voir figure 2) à l'intérieur de laquelle s'étend la plaque à circuit imprimé 36, parallèlement aux parois 44 et 46 et sensiblement à mi-hauteur entre les faces internes en vis-à-vis 45 et 47 des parois 44 et 46.

Selon la conception normalisée du boîtier 30, celui-ci est délimité transversalement par deux parois latérales opposées 50 et 52, qui sont parallèles à la direction générale longitudinale du boîtier 30 et qui sont ici constituées par des bords rabattus verticaux 54 et 56 de la demi-coquille inférieure 34 qui sont sertis autour des bords latéraux en vis-à-vis de la demi-coquille supérieure 32 dont l'un 58 est illustré à la figure 1.

Sans sortir du cadre de l'invention, le boîtier 30 peut être réalisé avec une coquille en une seule pièce.

Les parois latérales 50 et 52 du boîtier de raccordement 30 sont conformées en forme de rails de guidage du boîtier 30 dans des glissières correspondantes (non représentées) appartenant à la fente normalisée destinée à recevoir le boîtier 30.

A cet effet, les portions d'extrémité latérale des demi-coquilles supérieure 32 et inférieure 34 sont déformées 60, 62 pour conférer aux parois latérales 50 et 52 une hauteur réduite par rapport à la hauteur globale du boîtier 30, c'est-à-dire son épaisseur dans sa partie centrale.

Un connecteur 64 destiné à recevoir une carte C à circuit(s) intégré(s) à contact du type "MICRO SIM" est agencé à l'intérieur du boîtier 30.

Selon une conception connue, qui est par exemple décrite et représentée dans la demande de brevet français FR-A-2.742.561, le connecteur 64 est constitué pour l'essentiel par un support en matériau isolant 66 qui délimite dans sa face supérieure 68 un logement 70 de forme complémentaire de celui de la carte C et qui est destiné à recevoir au moins en partie cette dernière dont la face inférieure 72 comporte des plages conductrices 74 qui, lorsque la carte C est en position introduite dans le logement 70, sont en contact avec des extrémités de contact 76 appartenant à des lames de contact 78 du connecteur.

Conformément à ce mode de réalisation de l'invention, le connecteur 66 est prévu pour être monté avec la face inférieure 67 de l'isolant 66 en appui sur la face supérieure 37 de la plaque à circuit. imprimé 36.

Une fois le boîtier 30 assemblé et fermé avec le connecteur 64 porté par la plaque à circuit imprimé 10 et afin de permettre l'introduction et ou l'extraction de la carte C dans le connecteur 64, il est prévu une fente 80 qui, dans le mode de réalisation préféré illustré aux figures, est agencée au voisinage de l'une des parois latérales 50 du boîtier de raccordement 30.

Plus particulièrement, et comme on peut le voir en détail sur la figure 2, la fente d'introduction 80 s'étend pour l'essentiel dans la portion inclinée 82 de la partie latérale de la demi-coquille supérieure 32 qui relie la paroi principale supérieure 44 au pli 60 qui s'étend dans la portion plane 84 correspondant à la portion latérale d'épaisseur réduite du boîtier 30.

La portion 84' de la partie 84, qui s'étend au droit de la fente 80 découpée dans la partie inclinée 82, est légèrement déformée verticalement vers le bas par rapport au plan général de la partie 84.

La fente d'introduction 80 est ainsi délimitée par deux bords principaux supérieurs 86 et 88 et par deux bords d'extrémité 90 et 92.

Dans cette conception préférée de la fente 80, celle-ci ne s'étend pas dans la paroi supérieure principale 44 et sa largeur mesurée selon la direction générale longitudinale du boîtier, est légèrement supérieure à la largeur de la carte C de manière à permettre l'introduction et l'extraction de cette dernière selon une direction I qui est transversale par rapport à la direction générale longitudinale du boîtier.

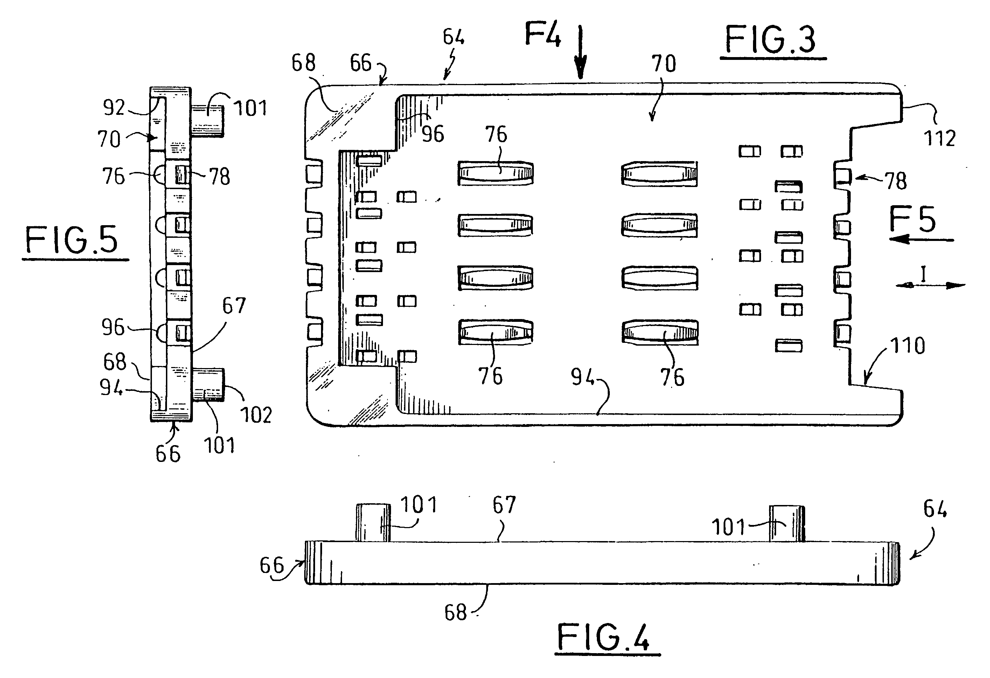

Comme cela a été représenté en détail aux figures 3 à 5, le logement 70 du connecteur 64 destiné à recevoir la carte C est délimité par deux bords opposés 92 et 94 qui sont parallèles à la direction d'introduction I et vers l'arrière, à gauche en considérant la figure 3, par un bord transversal arrière 96 qui, lorsque la carte C est en position introduite dans le logement 70, constitue une butée pour le bord transversal arrière 98 de la carte C.

A son autre extrémité avant, à droite en considérant la figure 3, le logement 70 est ouvert de manière à permettre l'introduction et l'extraction de la carte C dans le logement 70 par coulissement de cette dernière selon la direction I parallèlement au plan général de la carte C, la hauteur du logement 70 étant légèrement supérieure à l'épaisseur de la carte C.

Dans ce mode de réalisation du connecteur 64, celui-ci comporte, sur sa face inférieure 67, quatre pieds 101 en forme de pions cylindriques qui sont destinés, d'une part, à assurer le positionnement et la fixation du connecteur 64 sur la plaque à circuit imprimé 36, qui comporte à cet effet des trous correspondants 100 à travers laquelle s'étendent les pieds 101 et, d'autre part, à permettre au connecteur 64 d'assurer une fonction d'entretoise entre les plaques principales supérieure 44 et inférieure 46 du boîtier 30 afin d'éviter un écrasement intempestif du boîtier 30.

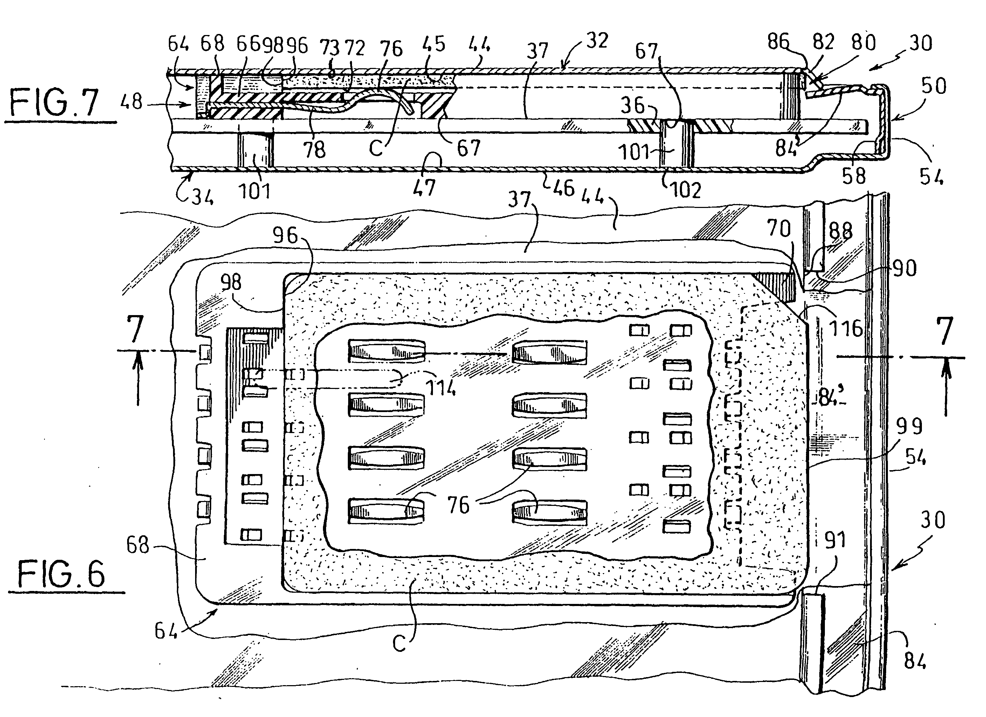

A cet effet, et comme on peut le voir notamment sur la figure 7, la hauteur des pieds 101 en forme de pions cylindriques formant entretoise est telle que la face d'extrémité inférieure 102 de chaque pied 101 est en contact avec la face interne 47 de la paroi inférieure 46 tandis que la face supérieure plane 68 du support isolant 66 du connecteur 64 est en appui contre la face interne en vis-à-vis 45 de la paroi supérieure 44.

Comme on peut le voir à la figure 3, la conception du connecteur 64, qui comporte un dégagement 110 formé dans son bord avant 112, et son positionnement sur la carte à circuit imprimé 36, par rapport à la fente 80, sont tels que les extrémités de raccordement des lames de contact 78 sont situées en retrait par rapport à la zone d'accès constituée par la fente 80 évitant ainsi tout risque de court-circuit accidentel en cas d'introduction d'un objet métallique dans la fente 80.

Comme on peut le voir aussi aux figures 6 et 7, lorsque la carte C est en position introduite dans le boîtier et ainsi en position de raccordement dans le logement 70 du connecteur 64, son bord transversal avant 99 est situé entièrement à l'intérieur du boîtier 30, c'est-à-dire légèrement en retrait vers l'intérieur par rapport au bord principal supérieur 86 de la fente d'introduction 80. Afin de faciliter l'introduction à fond de la carte, on peut prévoir une découpe supplémentaire dans le bord de la fente 80.

Le boîtier 30 équipé conformément aux enseignements de l'invention du connecteur 64 présente ainsi une "silhouette" extérieure, après introduction de la carte C, qui est identique à celle d'un boîtier classique de manière à permettre son introduction dans une fente correspondante d'un ordinateur personnel.

Les dimensions extrêmement réduites de la fente d'introduction 80 ne modifient pas la structure générale du boîtier 30, c'est-à-dire ni sa rigidité, et la fente n'affecte pas la fonction de blindage électromagnétique que le boîtier assure par rapport aux composants (non représentés) portés par la plaque à circuit imprimé 36.

Selon le premier mode de réalisation illustré aux figures 1 à 7, afin de permettre l'extraction de la carte C hors du boîtier 30, il est prévu dans la plaque principale supérieure 44 une entaille ou rainure d'extraction 114, qui est illustrée en trait mixte à la figure 6, qui s'étend transversalement par rapport au boîtier 30, c'est-à-dire parallèlement à la direction I d'introduction ou d'extraction de la carte. L'entaille 114 est positionnée de manière à s'étendre de part et d'autre du bord transversal arrière 98 de la carte C et, de préférence, en vis-à-vis d'une zone du connecteur 64 ne comportant pas de parties métalliques appartenant aux lames de contact 78.

Ainsi, il est possible d'introduire un outil de petite dimension dans l'entaille 114 pour agir sur le bord transversal arrière 98 de la carte C afin de la repousser hors de son logement 70, c'est-à-dire en la faisant coulisser de la gauche vers la droite en considérant la figure 6, sur la course permise par la longueur de l'entaille 114 de manière que son bord transversal avant 99 sorte au moins en partie du boîtier 30 par la fente 80 de façon que, à l'issue de cette première phase d'extraction, l'utilisateur puisse attraper la carte pour l'extraire entièrement du boîtier 30.

Selon la définition normalisée des cartes "MICRO SIM", dont un exemple est illustré dans le cadre de la présente description, la carte C comporte au voisinage de son bord transversal avant 99 un pan coupé 116 qui, pour certaines applications, constitue un moyen de détrompage de la position de la carte C dans son connecteur.

Afin de maintenir la carte C en position introduite dans le boîtier 30 et éviter son échappement accidentel hors du boîtier, même partiel, il peut être prévu un bossage 120 formé dans la paroi principal supérieure 44 au droit du pan coupé 116 et qui s'étend, sur une faible hauteur, à l'intérieur de la cavité 48, pour constituer une butée qui s'étend en regard du pan coupé 116.

Lors de l'extraction de la carte au moyen d'un outil introduit dans l'entaille 114, l'utilisateur doit appliquer un effort légèrement plus important de manière que, par une légère déformation élastique de la partie correspondante de la paroi supérieure 44, la butée constituée par le bossage 120 s'efface lors du passage du pan coupé 116 puis de la face supérieure 73 de la carte C.

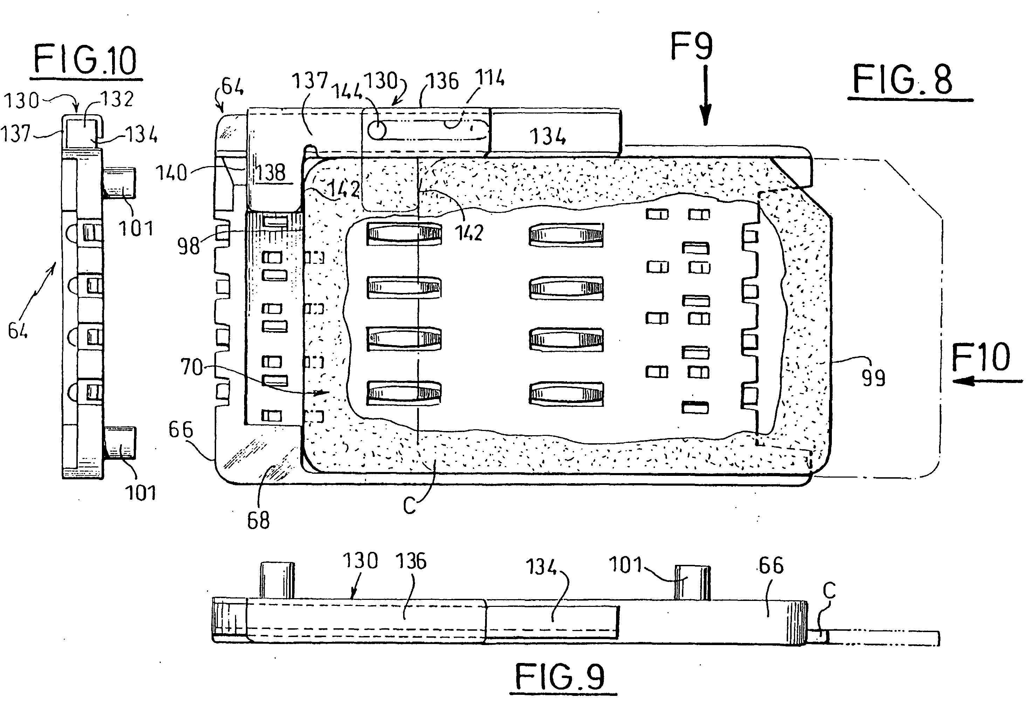

On décrira maintenant le mode de réalisation illustré aux figures 9 à 10 selon lequel le connecteur 64, qui est d'une conception légèrement différente de celle décrite et représentée précédemment, est équipé d'un chariot 130 d'extraction manuelle de la carte C.

A cet effet, le support en matériau isolant 66 du connecteur 64 comporte, sur l'un de ses bords latéraux 132, une glissière 134 sur laquelle est montée coulissante la portion latérale 136, en forme de coulisseau, du chariot d'extraction 130 qui se prolonge par une patte d'extraction 138 qui s'étend au-dessus de la face supérieure 68 du support 66, dans le plan correspondant à l'épaisseur de la carte C.

La patte d'extraction 138 est délimitée par un bord transversal arrière 140 qui, lorsque le chariot d'extraction est en position "carte introduite" (comme cela est représenté en trait fort à la figure 8), est en butée contre le bord transversal arrière 96 du logement 70. La patte 138 est aussi délimitée par un bord transversal avant 142 contre lequel vient en appui le bord transversal arrière 98 de la carte C.

Le chariot d'extraction 130 peut coulisser depuis sa position carte introduite, de la gauche vers la droite en considérant la figure 8, vers une position d'extraction de la carte C au cours de laquelle il provoque un déplacement simultané de la carte C du fait de la coopération du bord 142 de la patte 138 avec le bord transversal arrière 98 de la carte.

Afin d'entraîner en coulissement le chariot d'extraction 130, sa partie formant coulisseau 136 comporte une creusure 144 destinée à recevoir l'extrémité d'un outil de forme complémentaire qui est introduit dans une entaille de la face supérieure 44 du boîtier 30, qui est une entaille similaire à l'entaille 114 décrite précédemment mais qui s'étend alors en regard du coulisseau 136.

Cette conception est particulièrement avantageuse en ce qu'elle évite d'agir directement avec un outil sur le bord transversal arrière 98 de la carte C en évitant ainsi de détériorer la carte.

De plus, la face supérieure en forme de plaque 137 du coulisseau métallique 130 s'étend toujours en regard de l'entaille 114 assurant ainsi une fermeture électromagnétique de l'entaille 114.

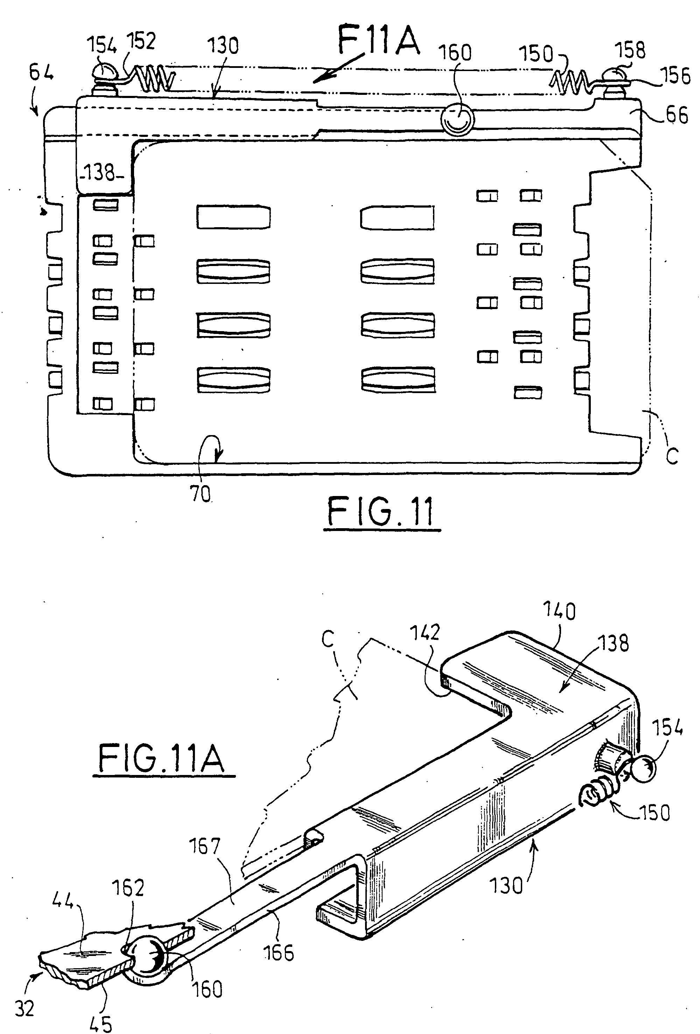

On décrira maintenant le mode de réalisation illustré aux figures 11 et 11A dans lequel le connecteur 64 est équipé d'un chariot 130 d'extraction de la carte qui assure une extraction automatique de cette dernière.

A cet effet, la conception du chariot d'extraction 103 est similaire à celle qui a été décrite en référence aux figures 8 à 10 mais il est équipé d'un ressort hélicoïdal de traction 150 qui le rappelle élastiquement en permanence vers une position d'extraction de la carte.

A cet effet, un première extrémité 152 du ressort est accrochée sur un ergot 154 appartenant au coulisseau 130 tandis que son extrémité opposée 156 est accroché, sur un ergot 158 réalisé venu de matière avec l'isolant 66 du connecteur 64.

Du fait de la présence du ressort de traction 150, la carte C, illustrée en silhouette à la figure 11, est sollicitée en permanence par la patte d'extraction 138, de la gauche vers la droite, c'est-à-dire selon une direction correspondant à son extraction hors du connecteur 64 et donc hors du boîtier 30.

Afin de maintenir la carte en position introduite, c'est-à-dire dans la position dans laquelle elle est illustrée en silhouette à la figure 11, il existe un moyen de verrouillage en position "carte introduite" du chariot d'extraction 130 qui est ici constitué par un doigt de verrouillage 160 qui est prévu pour être reçu en position "carte introduite", dans un trou complémentaire 162 formé en vis-à-vis dans la paroi principale supérieure 44 du boîtier 30, comme cela est illustré à la figure 11A.

Le doigt 160 est par exemple constitué par un bossage ou par une bille agencée à l'extrémité d'un bras 166 qui prolonge le corps principal du chariot d'extraction 130, dans le plan de la face supérieure 137 de ce dernier, la poutre constituée par le bras 166 pouvant être fléchie par déformation élastique verticalement vers le bas afin de faire échapper le doigt de verrouillage 160 hors du trou 162 par l'intermédiaire d'un outil (non représenté) au moyen duquel on appuie sur le doigt 160 qui est alors effacé vers l'intérieur du boîtier permettant une extraction automatique de la carte sous l'action du ressort 150, le doigt 160 frottant, au cours de la course d'extraction, contre la face interne en vis-à-vis 45 de la paroi principale supérieure 44.

Outre qu'elle permet d'assurer une extraction automatique de la carte, la conception du chariot d'extraction automatique 130 associé à un ressort d'extraction 150 permet de supprimer l'entaille 114 dans le boîtier 30 et de la remplacer par un simple trou 162 de petite dimension qui est obturé soit par l'extrémité du bras 166 constituant le doigt de verrouillage 160, soit par une portion en vis-à-vis de la face supérieure 167 du bras 166, au cours de la course d'extraction du chariot 130.

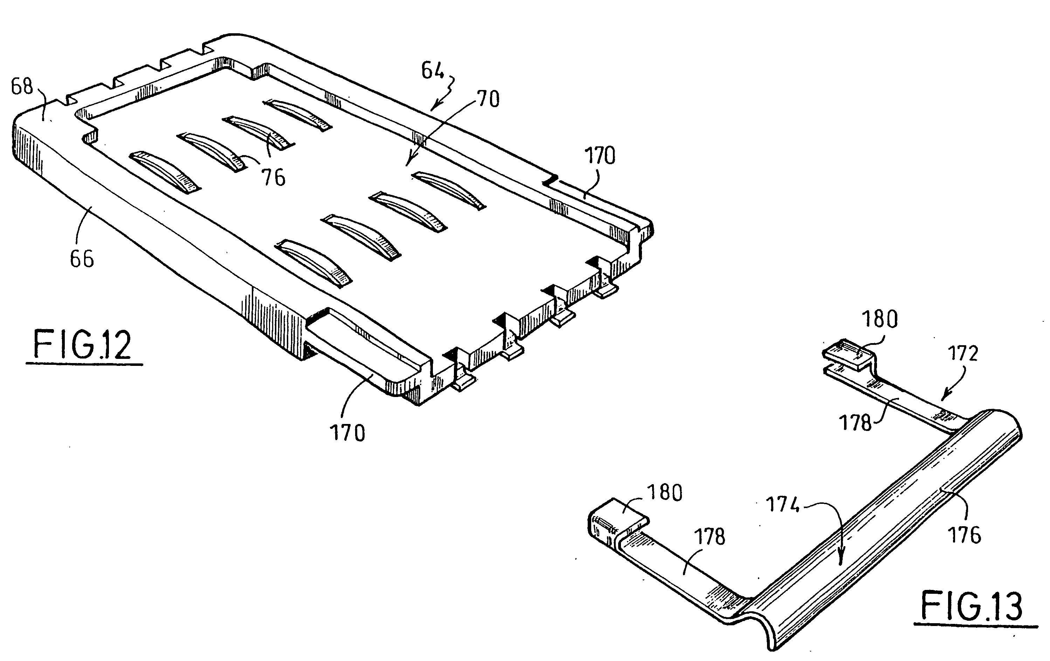

On décrira maintenant en référence aux figures 12 à 16 un premier exemple de réalisation de moyens d'obturation au moins partiels de la fente d'introduction 80.

A cet effet, le support en matériau isolant 66 du connecteur 64 est modifié dans sa partie avant, à droite en considérant la figure 12, pour comporter deux nervures longitudinales opposées 170 pour le montage en position fixe d'un dispositif d'obturation 172.

Le dispositif 172 est constitué pour l'essentiel par une lèvre d'obturation 174 de profil général incurvé semi-cylindrique creux dont la face supérieure convexe 176 est orientée vers le haut pour venir s'étendre à proximité et en regard de la fente 80.

La lèvre d'obturation 174 est reliée à deux bras parallèles longitudinaux et opposés 178 dont chacun porte à son extrémité libre une patte 180 pour l'accrochage du dispositif d'obturation 172 sur le connecteur 164 par insertion des nervures 170 dans les pattes d'accrochage recourbées en U.

Le dispositif d'obturation 172 est par exemple réalisé par découpage et emboutissage d'une tôle métallique de faible épaisseur.

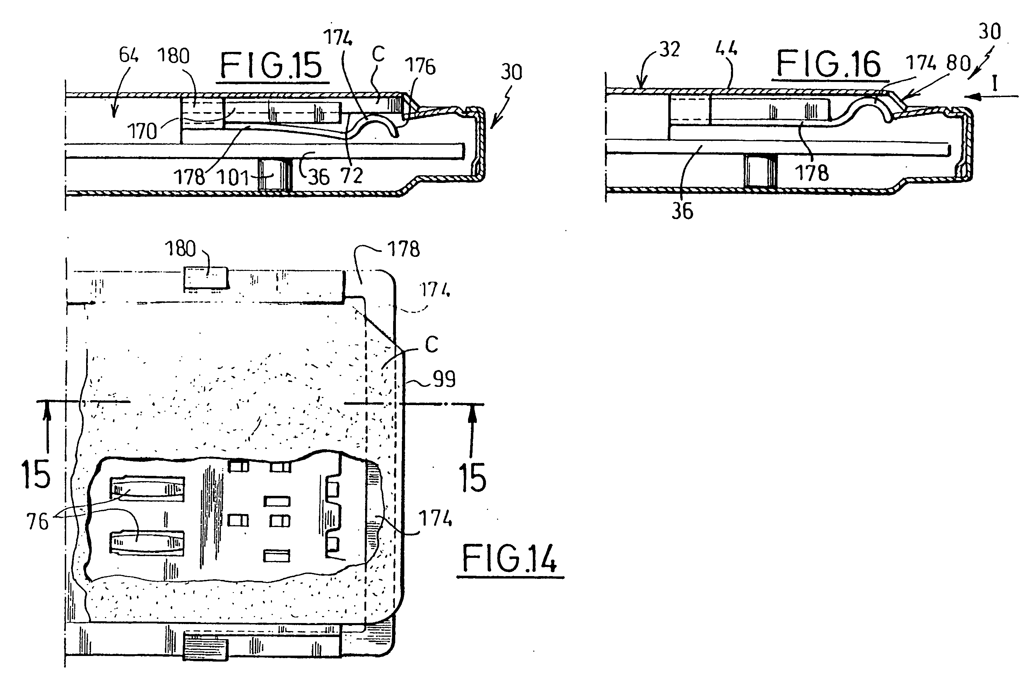

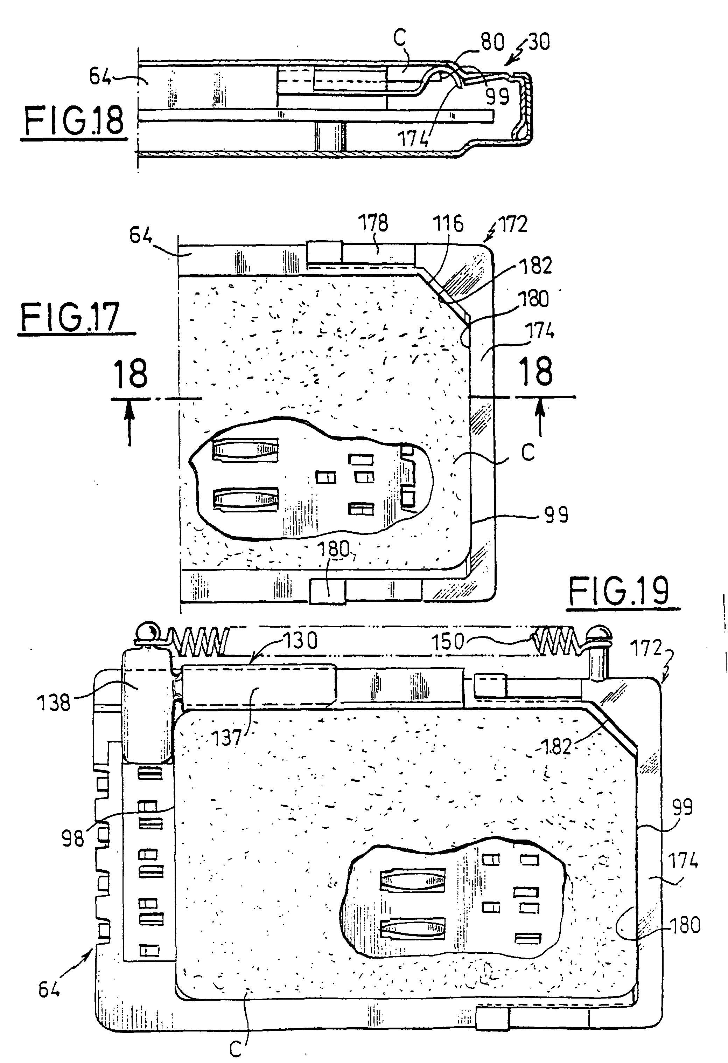

Comme on peut le voir aux figures 14 à 16, les bras 178 qui portent la lèvre d'obturation 174 s'étendent dans le plan des faces inférieures des nervures 170 et, par leur fléchissement vertical, ils permettent des déplacements dans un plan sensiblement vertical de la lèvre 174, entre sa position normalement effacée vers le bas lorsque la carte C est en place dans le connecteur 64 et une position normale de repos illustrée à la figure 16, dans laquelle, en l'absence de carte, la lèvre 174 s'étend devant la fente 80 qui est ici de dimension légèrement supérieure à celle illustrée précédemment, c'est-à-dire qu'elle s'étend légèrement vers l'intérieur du boîtier, dans la face supérieure 44 de la demi-coquille 32.

La lèvre d'obturation 174 s'escamote automatiquement lors de l'introduction de la carte C selon la direction I dans la mesure où le bord transversal arrière 98 de la carte C coopère avec la face supérieure 176 qui agit comme une came pour provoquer la déformation élastique des bras 178, la lèvre 174 étant alors en appui contre la portion en vis-à-vis de la face inférieure 72 de la carte C.

On décrira maintenant le mode de réalisation illustré aux figures 17 et 18 sur lesquelles le dispositif 172 d'obturation constitue aussi un dispositif de retenue de la carte C en position introduite dans le connecteur 64 et dans le boîtier 30.

A cet effet, la longueur des bras 178 est légèrement supérieure et la lèvre 174 comporte une découpe arrière 180 de profil complémentaire de celui du bord transversal avant 99 de la carte C avec un pan coupé 182.

En position introduite de la carte, le bord de la découpe arrière 180 s'étend en vis-à-vis du bord transversal avant 99 de la carte C et il est donc impossible d'extraire la carte, le dispositif d'obturation 172 assurant ainsi une fonction de verrouillage de la carte C en position introduite et évitant alors tout échappement accidentel de la carte.

Pour extraire la carte, quel que soit le mode d'extraction manuel ou automatique, il est nécessaire de provoquer un déverrouillage de celle-ci en agissant à travers la fente 80 au moyen d'un outil (non représenté) sur la lèvre 174 pour provoquer un déplacement vertical vers le bas de cette dernière jusqu'à ce qu'elle passe en-dessous du plan de la carte C pour libérer cette dernière qui peut alors coulisser, de la gauche vers la droite en considérant les figures 17 et 18 à l'extérieur du boîtier 30.

Dans la variante de réalisation illustrée à la figure 19, le dispositif d'obturation 172 est similaire à celui illustré aux figures 17 et 18 mais il est associé à un chariot d'extraction 130 du type de celui décrit et représenté aux figures 11 et 11A, l'ergot 158 pour l'accrochage du ressort d'extraction 150 étant réalisé venu de matière avec le dispositif d'obturation 172.

Grâce à cette conception, le chariot d'extraction automatique 130 peut être simplifié dans la mesure où il n'est pas nécessaire qu'il comporte ses propres moyens de verrouillage en position introduite de la carte, le verrouillage étant assuré par le dispositif d'obturation 172, la carte étant en permanence sollicitée par le chariot d'extraction 130 de manière que son bord transversal avant 99 soit en butée contre le bord de la découpe arrière 180 de la lèvre 174.

Pour provoquer l'extraction automatique de la carte C, il suffit d'agir, comme dans le cas du mode de réalisation décrit en référence aux figures 17 et 18, sur la lèvre 174 à travers le fente 80 pour provoquer l'effacement de la lèvre 174 et l'extraction automatique de la carte C qui est alors sollicitée de la gauche vers la droite en considérant la figure 19 par le chariot d'extraction 130.

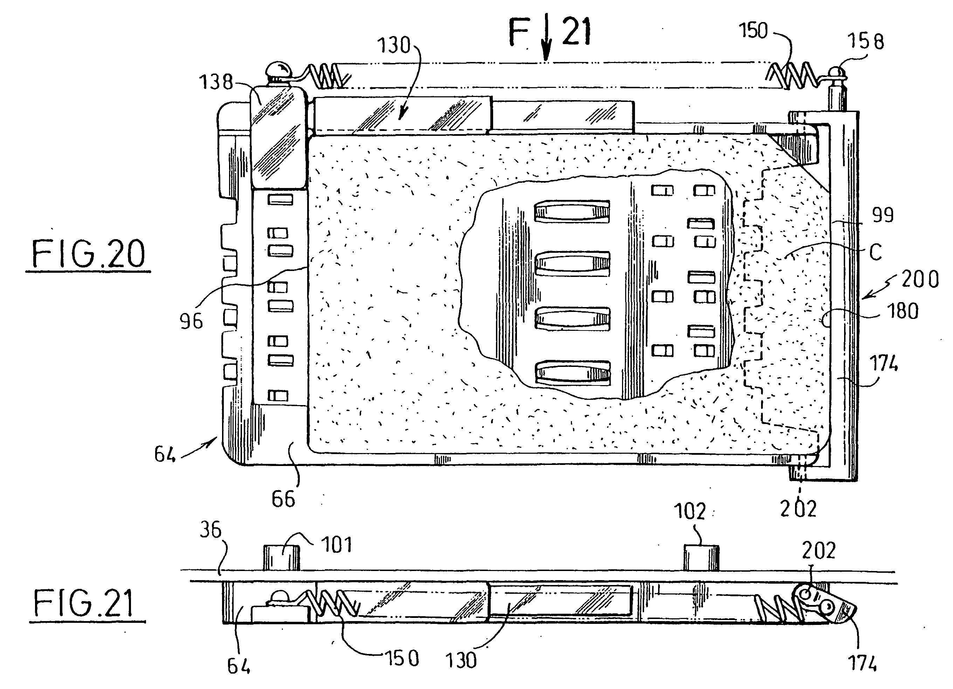

Dans le mode de réalisation illustré aux figures 20 et 21, le dispositif de verrouillage de la carte est constitué par une bascule 200 montée pivotante sur l'isolant 66 du connecteur 64 autour d'un axe 202, le ressort d'extraction 150 étant accroché sur un ergot qui est porté par la bascule 200 de manière à solliciter cette dernière en permanence dans la position de verrouillage de la carte dans laquelle la découpe arrière 180 de la bascule 200 s'étend en regard du bord transversal avant 99 de la carte C lorsque cette dernière est en position introduite, comme cela est illustré notamment sur la figure 20.

La face supérieure 174 de la bascule 200 assure une fonction équivalente à celle de la lèvre d'obturation 174 dans la mesure où elle peut s'étendre dans la fente d'obturation 80.

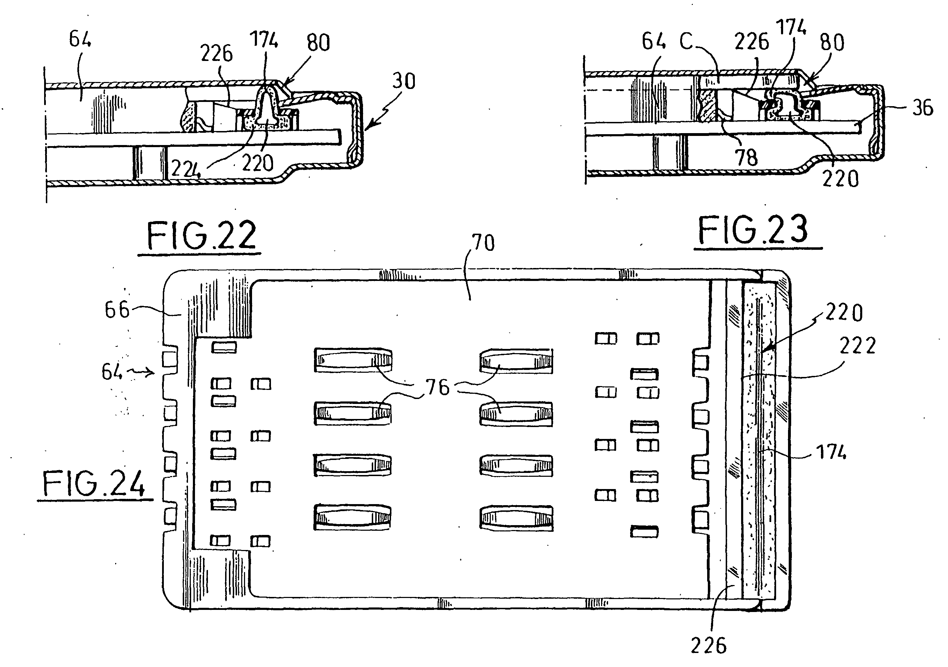

On se reportera maintenant aux figures 22 à 24 sur lesquelles est illustrée une autre conception des moyens d'obturation de la fente 80.

Ces moyens d'obturation sont ici constitués par un joint d'obturation 220 qui est agencé dans un logement de forme complémentaire 222 formé dans l'isolant 66 du connecteur 64 au voisinage du bord avant de ce dernier.

Le joint d'obturation 220 comporte, à sa partie supérieure, une lèvre d'étanchéité 174 qui s'étend normalement en regard de la fente d'introduction 80, c'est-à-dire lorsqu'il n'y pas de carte dans le boîtier 30, et qui peut s'effacer par déformation élastique lorsque l'on introduit une carte C dans le boîtier 30 par la fente 80, comme cela est illustré à la figure 23.

Le joint d'obturation 220 est monté dans le logement 222 par l'intermédiaire de son talon 224, une rampe 226 étant prévue dans l'isolant 66 pour faciliter l'introduction de la carte, c'est-à-dire pour la ramener au niveau du fond du logement 70.

Enfin, le fond du logement comporte, au voisinage de son bord avant, une rampe 236 qui permet de soulever la carte lors de son extraction afin de l'orienter à travers la fente 80 et pour franchir une marche de faible épaisseur qui constitue une butée de retenue de la carte dans le connecteur et qui est adjacente à la rampe. Dans ce cas, le bossage 120 est inutile.

La fente 80 peut, à titre de variante, être agencée transversalement avec la direction I parallèle à la direction générale longitudinale du boîtier, dans la coquille ou à une extrémité longitudinale du boîtier.

Dans le cas où il n'est pas prévu de moyens d'obturation de la fente 80, on constate que la poussière qui pénètre dans le boîtier est confinée dans le logement 70 et ne peut s'étendre à l'intérieur du boîtier 30.

## Revendications

1. Boîtier (30) de raccordement électronique, notamment pour un ordinateur individuel, en forme générale de carte du type comportant une coquille (32, 34) à parois principales planes parallèles et opposées (44, 46), supérieure et inférieure, qui délimitent entre elles une cavité (48), ouverte à ses deux extrémités longitudinales opposées et délimitée transversalement par deux parois latérales opposées (50) conformées en forme de rails de guidage du boîtier, et à l'intérieur de laquelle est agencée une plaque intermédiaire (36), notamment une plaque à circuit imprimé, qui s'étend sensiblement à mi-hauteur entre les faces internes en vis à vis (45, 47) des parois principales et parallèlement à ces dernières, le boîtier (30) contenant un connecteur (64), pour relier électriquement au boîtier une carte à circuit(s) intégré(s) à contact (C), qui comporte un support (66) en matériau isolant agencé sur la face supérieure (37) de la plaque intermédiaire (36), la coquille (32) comportant une fente (80) pour l'introduction, ou l'extraction, de la carte (C) dans le boîtier selon une direction (I) sensiblement parallèle au plan de la carte (C), et dans lequel boitier, en position introduite, la carte (C) est agencée entièrement à l'intérieur du boîtier (30), **caractérisé en ce que** le boitier comporte des moyens d'extraction de la carte hors du boîtier, lesdits moyens d'extraction comportant un chariot d'extraction (130) situé entièrement dans le boîtier lorsque la carte (C) est en position introduite monté coulissant sur le support (66) du connecteur, entre une position introduite de la carte (C) et une position d'extraction dans laquelle la carte fait au moins en partie saillie à l'extérieur du boîtier, **en ce que** le chariot d'extraction (130) comporte un bord transversal avant actif (142) qui s'étend en regard du bord transversal arrière (98) de la carte (C), et **en ce qu'**il est prévu des moyens de commande des déplacements en coulissement du chariot accessibles depuis l'extérieur du boîtier.

2. Boîtier de raccordement électronique selon la revendication 1, **caractérisé en ce que** le chariot d'extraction (130) est rappelé élastiquement (150) vers la position d'extraction de la carte (C), et **en ce qu'**il est retenu dans la position introduite de la carte par des moyens de verrouillage automatique.

3. Boîtier de raccordement électronique selon la revendication 2, **caractérisé en ce que** les moyens de verrouillage automatique du chariot (130) comportent un doigt escamotable (160) de verrouillage porté par le chariot (130) et qui, en position introduite de la carte (C), est reçu dans un trou en vis-à-vis (162) de la paroi principale supérieure (44) du boîtier vers lequel il est rappelé élastiquement.

4. Boîtier de raccordement selon la revendication 2, **caractérisé en ce que** les moyens de verrouillage automatique du chariot (130) comportent une barre de verrouillage escamotable (172) portée par le support (66) du connecteur (64) et qui s'étend normalement dans une position de verrouillage de la carte (C) en position introduite vers laquelle elle est rappelée élastiquement et dans laquelle la barre (172) s'étend en regard du bord transversal avant (99) de la carte.

5. Boîtier de raccordement électronique selon la revendication 4, **caractérisé en ce que** la barre de verrouillage (172) s'étend normalement en regard de la fente d'introduction (80) de la carte (C) dans le boîtier, et **en ce que** la barre de verrouillage comporte un profil de came (174) avec lequel coopère le bord transversal arrière (98) de la carte (C) lors de son introduction pour provoquer l'escamotage de la barre de verrouillage (172) selon une direction sensiblement verticale.

6. Boîtier de raccordement électronique selon l'une quelconque des revendications précédentes, **caractérisé en ce que** le support (66) du connecteur (64) comporte des moyens (101) pour son positionnement qui coopèrent avec des moyens complémentaires (100) de la plaque intermédiaire (36).

7. Boîtier de raccordement électronique selon la revendication 6, **caractérisé en ce que** les moyens de positionnement du connecteur sont des moyens par coopération de formes complémentaires.

8. Boîtier de raccordement électronique selon l'une des revendications 6 ou 7, **caractérisé en ce que** le support du connecteur comporte au moins une partie (101) formant entretoise qui s'étend à travers la plaque intermédiaire (36) et dont la face inférieure d'extrémité libre (102) est adjacente à la face interne (47) en vis à vis de la paroi principale inférieure (46).

9. Boîtier de raccordement électronique selon la revendication 7 prise en combinaison avec la revendication 6, **caractérisé en ce que** la partie formant entretoise (101) s'étend à travers une ouverture (100) de forme complémentaire de la plaque intermédiaire (36).

10. Boîtier de raccordement électronique selon l'une quelconque des revendications précédentes, **caractérisé en ce que** le boitier comprend des moyens (174) d'obturation au moins partielle de la fente (80) d'introduction de la carte dans le boîtier.

11. Boîtier de raccordement électronique selon la revendication 10, **caractérisé en ce que** les moyens d'obturation sont des moyens déformables élastiquement qui, au repos, s'étendent en regard de la fente d'introduction (80) et qui sont susceptibles de s'effacer automatiquement lors de l'introduction de la carte (C).

12. Boîtier de raccordement électronique selon la revendication 11 prise en combinaison avec la revendication 6, **caractérisé en ce que** les moyens d'obturation sont portés par le support (66) du connecteur.

13. Boîtier de raccordement électronique selon la revendication 12, **caractérisé en ce que** les moyens d'obturation comportent une lèvre d'obturation (174) qui est montée mobile verticalement par rapport au support (66) du connecteur (64) et qui comporte un profil de came (76) avec lequel coopère le bord transversal arrière (98) de la carte (C) lors de son introduction pour provoquer l'escamotage de la lèvre (174) selon une direction sensiblement verticale.

14. Boîtier de raccordement électronique selon la revendication 13, **caractérisé en ce que** la lèvre est une lame profilée (174) portée par le support (66) du connecteur (64) par l'intermédiaire de deux bras déformables élastiquement qui s'étendent longitudinalement le long de bords du support (66) parallèles à la direction d'insertion de la carte (C).

15. Boîtier de raccordement électronique selon la revendication 13, **caractérisé en ce que** la lèvre d'obturation (174) appartient à un joint d'obturation (220) monté dans un évidement (222) formé dans la face supérieure du support du connecteur (64).

16. Boîtier de raccordement électronique selon l'une quelconque des revendications précédentes, **caractérisé en ce que** la paroi principale supérieure (44) comporte, sur sa face interne (45), un bossage (120) qui, lorsque la carte (C) est en position introduite, s'étend en regard d'une portion (116) du bord transversal avant (99) de la carte (C) pour éviter tout échappement accidentel de cette dernière hors du boîtier (30).

17. Boîtier de raccordement électronique selon l'une quelconque des revendications précédentes, **caractérisé en ce que** le support (66) comporte un logement (70) ouvert dans sa face supérieure (68), et **en ce que** le fond du logement (70) de la carte comporte une rampe (236) qui, provoque un soulèvement du bord transversal avant de la carte lors de son mouvement d'extraction hors du boîtier (30).

## Claims

1. Electronic connection unit (30), in particular for a personal computer, in the general form of a card of the type comprising a shell (32, 34) with upper and lower parallel and opposite plane main walls (44, 46) which, between them, delimit a cavity (48) which is open at its two opposite longitudinal ends and is transversely delimited by two opposite side walls (50), designed in the form of guide rails for the unit, and inside which cavity an intermediate board (36), in particular a printed-circuit board, is arranged which extends substantially halfway between the opposite inner faces (45, 47) of the main walls, and parallel to the latter, the unit (30) housing a connector (64), for electrically connecting a contact card (C) with integrated circuit(s), which includes a support (66) made of insulating material, arranged on the upper face (37) of the intermediate board (36), the shell (32) having a slot (80) for insertion or extraction of the card (C) into or from the unit in a direction (I) substantially parallel to the plane of the card (C), and in which unit, when inserted, the card (C) is arranged entirely inside the unit (30), **characterised in that** the unit includes means for extracting the card from the unit, said extraction means including an extraction carriage (130) entirely received in the unit when the card (C) is in the inserted position, mounted so as to slide on the support (66) of the connector between a card (C) insertion position and an extraction position in which the card at least partly projects out of the unit, **in that** the extraction carriage (130) includes an active front transverse edge (142) which extends facing the rear transverse edge (98) of the card (C), and **in that** means, accessible from outside the unit, are provided for controlling the sliding displacements of the carriage.

2. Electronic connection unit according to Claim 1, **characterised in that** the extraction carriage (130) is returned elastically (150) towards the card (C) extraction position, and **in that** it is retained in the card insertion position by automatic locking means.

3. Electronic connection unit according to Claim 2, **characterised in that** the means for automatically locking the carriage (130) include a retractable locking finger (160) which is carried by the carriage (130) and which, in the card (C) insertion position, is received in an opposite hole (162) in the upper main wall (44) of the unit, towards which hole it is elastically returned.

4. Electronic connection unit according to Claim 2, **characterised in that** the means for automatically locking the carriage (130) include a retractable locking bar (172) which is carried by the support (66) of the connector (64) and normally extends in a position for locking the card (C) in the inserted position, towards which it is elastically returned and in which the bar (172) extends facing the front transverse edge (99) of the card.

5. Electronic connection unit according to Claim 4, **characterised in that** the locking bar (172) normally extends facing the slot (80) for inserting the card (C) into the unit, and **in that** the locking bar includes a cam profile (174), with which the rear transverse edge (98) of the card (C) interacts when it is being inserted, in order to cause retraction of the locking bar (172) in a substantially vertical direction.

6. Electronic connection unit according to anyone of the preceding claims, **characterised in that** the support (66) of the connector (64) includes means (101) for positioning it, which interact with complementary means (100) of the intermediate board.

7. Electronic connection unit according to claim 6, **characterised in that** the means for positioning the connector are complementary shaped interaction means.

8. Electronic connection unit according to any one of Claims 6 or 7, **characterised in that** the support of the connector includes at least one part (101) forming a spacer, which extends through the intermediate board (36) and the free lower end face (102) of which is adjacent to the opposite inner face (47) of the lower main wall (46).

9. Electronic connection unit according to Claim 7, taken in combination with Claim 6, **characterised in that** the part (101) which forms a spacer extends through an opening (100), of complementary shape, in the intermediate board (36).

10. Electronic connection unit according to any one of the preceding claims, **characterised in that** the unit comprises means (174) at least partially closing the slot (80) for inserting the card into the unit.

11. Electronic connection unit according to Claim 10, **characterised in that** the closure means are elastically deformable means which, at rest, extend facing the insertion slot (80) and which can be withdrawn automatically when the card (C) is being inserted.

12. Electronic connection unit according to Claim 11 taken in combination with claim 6, **characterised in that** the closure means are carried by the support (66) of the connector.

13. Electronic connection unit according to Claim 12, **characterised in that** the closure means include a closure lip (174) which is mounted so as to move vertically with respect to the support (66) of the connector (64) and includes a cam profile (76) with which the rear transverse edge (98) of the card (C) interacts when it is being inserted, in order to cause retraction of the lip (174) in a substantially vertical direction.

14. Electronic connection unit according to Claim 13, **characterised in that** the lip is a profiled strip (174), carried by the support (66) of the connector (64) via two elastically deformable arms which extend longitudinally along edges of the support (66) parallel to the insertion direction of the card.

15. Electronic connection unit according to Claim 13, **characterised in that** the closure lip (174) belongs to a closure seal (220) mounted in a recess (222) formed in the upper face of the support of the connector (64).

16. Electronic connection unit according to any one of the preceding claims, **characterised in that**, on its inner face (45), the upper main wall (44) includes a boss (120) which, when the card (C) is in the inserted position, extends facing a portion (116) of the front transverse edge (99) of the card (C) in order to prevent any accidental ejection of this card from the unit (30).

17. Electronic connection unit according to anyone of the preceding claims, **characterised in that** the support (66) includes an open housing (70) in its upper face (68), and **in that** the bottom of the housing (70) for the card includes a ramp (236) which causes the front transverse edge of the card to be raised during the movement for extracting it from the unit (30).

## Patentansprüche

1. Elektronisches Anschlußgehäuse (30) insbesondere für einen Individualcomputer. mit der allgemeinen Form einer Karte vom Typ, die eine Hülle (32, 34) mit oberen und unteren parallelen und gegenüberliegenden ebenen Hauptwänden (44. 46) umfaßt, die zwischen sich einen Hohlraum (48) begrenzen, der an seinen zwei gegenüberliegenden Längsenden offen ist und der transversal durch zwei gegenüberliegende Seitenwände (50) begrenzt ist, die in der Form den Schienen zur Führung des Gehäuses entsprechen und in dessen Inneren eine Zwischenplatte (36) angeordnet ist, insbesondere eine gedruckte Schaltkreisplatine, die sich im wesentlichen auf der mittleren Höhe zwischen den gegenüberliegenden Innenseiten (45. 47) der parallel zu der letzteren liegenden Hauptwände erstreckt. wobei das Gehäuse (30) einen Stecker (64) umfaßt. um mit dem Gehäuse elektrisch eine Karte mit integriertem Schaltkreis mit Kontakten (C) zu verbinden, der eine Halterung (66) aus isolierendem Material umfaßt, angeordnet auf der Oberseite (37) der Zwischenplatte (36) wobei die Hülle (32) ein Fenster (80) für das Einführen oder die Extraktion der Karte (C) in das Gehäuse in einer Richtung (I) umfaßt. die im wesentlichen parallel zur Ebene der Karte (C) ist und in dem. mit dem Gehäuse in eingeführter Position, die Karte (C) vollständig im Inneren des Gehäuses (30) angeordnet ist, **dadurch gekennzeichnet, daß** das Gehäuse Extraktionseinrichtungen für die Karte aus dem Gehäuse umfaßt. wobei die Extraktionseinrichtungen einen Extraktionswaen (130) umfassen, der vollständig in dem Gehäuse angeordnet ist. wenn sich die Karte (C) in eingeführter Position befindet, gleitend montiert auf der Halterung (66) des Steckers. zwischen einer eingeführten Position der Karte (C) und einer Extraktionsposition. in der die Karte zumindest teilweise über das Äußere des Gehäuses hervorsteht. dadurch. daß der Extraktionswagen (130) einen aktiven transversalen vorderen Rand (142) umfaßt. der sich gegenüber dem transversalen hinteren Rand (98) der Karte (C) erstreckt, und dadurch, daß Einrichtungen zur Steuerung des Versatzes des Gleitens des Wagen vorgesehen sind. die von außerhalb des Gehäuses zugänglich sind.

2. Elektronisches Anschlußgehäuse nach Anspruch 1, **dadurch gekennzeichnet, daß** der Extraktionswagen (130) elastisch (150) in die Extraktionsposition der Karte (C) gedrückt ist und dadurch, daß der in der eingeführten Position der Karte durch automatische Verriegelungseinrichtungen gehalten wird.

3. Elektronisches Anschlußgehäuse nach Anspruch 2, **dadurch gekennzeichnet, daß** die automatischen Verriegelungseinrichtungen des Wagens (130) einen einziehbaren Finger (160) zur Verriegelung umfassen. der von dem Wagen (130) getragen wird und der. in eingeführter Position der Karte (C) in ein Loch gegenüber (162) der oberen Hauptwand (44) des Gehäuses zurückgezogen ist. in deren Richtung er elastisch gedrückt wird.

4. Elektronisches Anschlußgehäuse nach Anspruch 2, **dadurch gekennzeichnet, daß** die autmatischen Verriegelungseinrichtungen des Wagens (130) einen einziehbaren Verriegelungsbolzen (172) umfassen, der von der Halterung (66) des Steckers (64) getragen wird und der sich normalerweise in eine Verriegelungsposition der Karte (C) in eingeführter Position erstreckt, in die er elastisch gedrückt wird und in der sich der Bolzen (172) gegenüber dem transversalen vorderen Rand (99) der Karte erstreckt.

5. Elektronisches Anschlußgehäuse nach Anspruch 4. **dadurch gekennzeichnet, daß** der Verriegelungsbolzen (172) sich normalerweise gegenüber dem Einführfenster (80) der Karte (C) in das Gehäuse erstreckt und dadurch, daß der Verriegelungsbolzen ein Nockenprofil (174) umfaßt, mit dem er mit dem transversalen hinteren Rand (98) der Karte (C) kooperiert, während deren Einführen, um ein Zurückweichen des Verriegelungsbolzens (172) in eine im wesentlichen vertikale Richtung zu provozieren.

6. Elektronisches Anschlußgehäuse nach einem der vorhergehenden Ansprüche, **dadurch gekennzeichnet, daß** die Halterung (66) des Steckers (64) Einrichtungen (101) für seine Positionierung umfaßt. die mit komplementären Einrichtungen (100) der Zwischenplatte (36) kooperieren.

7. Elektronisches Anschlußgehäuse nach Anspruch 6. **dadurch gekennzeichnet, daß** die Positioniereinrichtungen des Steckers Einrichtungen zur Kooperation mit komplementären Formen sind.

8. Elektronisches Anschlußgehäuse nach einem der Ansprüche 6 oder 7, **dadurch gekennzeichnet, daß** die Halterung des Steckers zumindest einen Teil (101) umfaßt. der eine Versteifung bildet, die sich über die Zwischenplatte (36) erstreckt und deren unteres freies Ende (102) an die gegenüberliegende Innenseite (47) der unteren Hauptwand (46) angrenzt.

9. Elektronisches Anschlußgehäuse nach Anspruch 7 in Kombination mit Anspruch 6. **dadurch gekennzeichnet, daß** der Teil, der die Versteifung (101) bildet, sich durch eine Öffnung (100) von komplementärer Form durch die Zwischenplatte (36) erstreckt.

10. Elektronisches Anschlußgehäuse nach einem der vorhergehenden Ansprüche. **dadurch gekennzeichnet, daß** das Gehäuse Einrichtungen (174) zur zumindest teilweisen Abdeckung des Fensters (80) zum Einführen der Karte in das Gehäuse umfaßt.

11. Elektronisches Anschlußgehäuse nach Anspruch 10, **dadurch gekennzeichnet, daß** die Abdeckeinrichtungen elastisch deformierbare Einrichtungen sind. die, in Ruhestellung. sich gegenüber dem Einführfenster (80) erstrecken und die in der Lage sind. beim Einführen der Karte (C) automatisch zurückzuweichen.

12. Elektronisches Anschlußgehäuse nach Anspruch 11 in Kombination mit Anspruch 6. **dadurch gekennzeichnet, daß** die Abdeckeinrichtungen von der Halterung (66) des Steckers getragen werden.

13. Elektronisches Anschlußgehäuse nach Anspruch 12, **dadurch gekennzeichnet, daß** die Abdeckeinrichtungen eine Abdeckzunge (174) umfassen, die vertikal beweglich gegenüber der Halterung (66) des Steckers (64) montiert ist und die ein Nockenprofil (76) umfaßt, mit dem sie mit dem transversalen hinteren Rand (98) der Karte (C) während des Einführens derselben kooperiert, um ein Zurückweichen der Zunge (174) in eine im wesentlichen vertikale Richtung zu provozieren.

14. Elektronisches Anschlußgehäuse nach Anspruch 13. **dadurch gekennzeichnet. daß** die Lippe eine profilierte Zunge (174) ist, die von der Halterung (66) des Steckers (64) mittels zweier elastisch deformierbarer Arme getragen wird, die sich längs entlang der Ränder der Halterung (66) parallel zur Einführrichtung der Karte (C) erstrecken.

15. Elektronisches Anschlußgehäuse nach Anspruch 13, **dadurch gekennzeichnet. daß** die Abdecklippe (174) zu einer Abdeckdichtung (220) gehört, die in einer Ausnehmung (222) montiert ist, ausgebildet in der Oberseite der Halterung des Steckers (64).

16. Elektronisches Anschlußgehäuse nach einem der vorhergehenden Ansprüche, **dadurch gekennzeichnet, daß** die obere Hauptwand (44) auf ihrer Innenseite (45) einen Höcker (120) umfaßt, der, wenn die Karte (C) in eingeführter Position ist, sich gegenüber einem Bereich (116) des transversalen vorderen Randes (99) der Karte (C) erstreckt. um jedes zufällige Herausfallen der letzteren aus dem Gehäuse (30) zu vermeiden.

17. Elektronisches Anschlußgehäuse nach einem der vorhergehenden Ansprüche, **dadurch gekennzeichnet, daß** die Halterung (66) eine offene Aufnahme (70) in ihrer Oberseite (68) umfaßt und dadurch. daß der Boden der Aufnahme (70) der Karte eine Rampe (236) umfaßt. die ein Anheben des transversalen vorderen Randes der Karte bei deren Extraktionsbewegung aus dem Gehäuse (30) provoziert.
